Europäisches Patentamt

European Patent Office

Office européen des brevets

(11) Veröffentlichungsnummer: **0 319 727**

**A2**

## EUROPÄISCHE PATENTANMELDUNG

(21) Anmeldenummer: **88118763.7**

(22) Anmeldetag: **10.11.88**

(51) Int. Cl.4: **H03H 11/04**

(30) Priorität: **11.12.87 DE 3742116**

(43) Veröffentlichungstag der Anmeldung:
**14.06.89 Patentblatt 89/24**

(84) Benannte Vertragsstaaten:
**AT BE CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Haass, Adolf, Ing.(grad)**
**Eichelhäherweg 54**
**D-8000 München 60(DE)**

(54) **Schaltungsanordnung für ein Tiefpass-Filter mit steuerbarer Grenzfrequenz.**

(57) Tiefpaßfilter mit einem Tiefpaß-Kondensator in einem Querzweig enthält in einem Längszweig einen aus Bipolar-Transistoren aufgebauten Differenzverstärker, mit dessen Hilfe in Abhängigkeit von und proportional zu einer zugeführten, variablen, steuernden Pulstaktfrequenz die Grenzfrequenz einstellbar ist. Tiefpaß-Kondensator liegt zur Bildung des Querzweiges am Ausgang des Differenzverstärkers. Dieser ist mit einer ebenfalls aus einem Bipolar-Transistor gebildeten Konstantstromquelle verbunden. Mit der Pulstaktfrequenz eintreffende Impulse werden einem monostabilen Kippglied zugeführt, dessen Ausgangsimpulse - über ein Integrationsglied geführt - zur Bildung einer die Konstantstromquelle proportional steuernden Steuerspannung dienen.

EP 0 319 727 A2

## Schaltungsanordnung für Tiefpaß-Filter mit steuerbarer Grenzfrequenz.

Die Erfindung bezieht sich auf eine Schaltungsanordnung für Tiefpaß-Filter mit einem Tiefpaß-Kondensator in einem Querzweig und mit solchen Schaltmitteln in einem Längszweig, durch die in Abhängigkeit von und proportional zu einer zugeführten, variablen, steuernden Impulstaktfrequenz die Grenzfrequenz des Tiefpasses einstellbar ist.

Eine Schaltungsanordnung dieser Art ist bereits durch die Zeitschrift "Electronic" 8/18.4.1986, Seite 54, bekannt. Tiefpaß-Filter der hier beschriebenen Art weisen die Möglichkeit auf, ihre Grenzfrequenz in einem großen Bereich zu variieren. Hierzu ist es bekannt, die jeweiligen RC-Verhältnisse durch entsprechende Umschaltungsmaßnahmen zu verändern. Nach Anzahl der verschiedenen Grenzfrequenzen, die einstellbar sein sollen, müssen entsprechend viele Widerstände vorgesehen werden, sowie Schalter mit entsprechend vielen verschiedenen Schaltstellungen, bzw. entsprechend viele elektronische Schalter zur Realisierung dieser Schaltstellungen. - Durch die zuvor genannte Literaturstelle ist eine Schaltungsanordnung bekannt geworden, bei der ein bei bekannten Tiefpaß-Schaltungen im Längszweig vorgesehener Widerstand durch zwei in Reihe geschaltete Schalter ersetzt ist, und bei der ein weiterer Kondensator zwischen diesen beiden Schaltern angeschlossen ist und einen Querzweig bildet. Die beiden Schalter werden von zwei nicht überlappenden komplementären Taktphasen gesteuert, und zwar mit der bereits erwähnten Pulstaktfrequenz. Als Nachteil ergeben sich bei einer Schaltungsanordnung dieser bekannten Art die durch das Schalten bedingten Störeinspeisungen. Außerdem werden diese Schalter üblicherweise ausschließlich in CMOS Technologie realisiert, weswegen aber dieses Prinzip bei Bipolarschaltungen nicht gut anwendbar ist.

Für die Erfindung besteht die Aufgabe, in einer Schaltungsanord nung der eingangs angegebenen Art Umschaltungen in RC-Gliedern zu vermeiden und die Grenzfrequenz des Tiefpasses stufenlos einstellbar zu machen nach Maßgabe der jeweils zugeführten Pulstaktfrequenz. Mit Hilfe einer relativ hohen Pulstaktfrequenz soll eine relativ hohe Grenzfrequenz eingestellt werden - und umgekehrt.

Die Erfindung löst die gestellte Aufgabe dadurch, daß im Längszweig ein aus Bipolar-Transistoren aufgebauter Differenzverstärker liegt, dessen Collectorwiderstand durch eine Stromspiegelschaltung realisiert ist, und an dessen Ausgang zur Bildung des Querzweiges der Tiefpaß-Kondensator angeschlossen ist, und der mit einer ebenfalls aus einem Bipolar-Transistor gebildeten Konstantstromquelle verbunden ist, und daß mit der Pulstaktfrequenz eintreffende Impulse einem monostabilen Kippglied zugeführt werden, dessen Ausgangsimpulse - über ein vorzugsweise aus einem Längswiderstand und einem Querkondensator bestehenden Integrationsglied geführt - zur Bildung einer die Konstantstromquelle steuernden, zur Frequenz proportionalen Steuerspannung dienen.

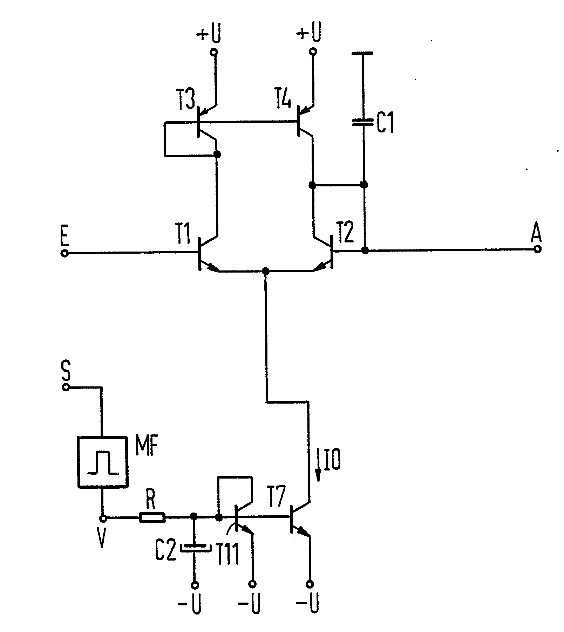

In der Zeichnung ist ein Ausführungsbeispiel der Erfindung nur in wesentlich zu ihrem Verständnis beitragenden Bestandteilen dargestellt, worauf diese jedoch keineswegs beschränkt ist.

Über einen Eingangsanschluß E eintreffende Eingangssignale sind an einen Ausgangsanschluß A weiterzugeben. Dies Eingangssignale weisen eine ihnen eigene Signalfrequenz auf. Sie durchlaufen einen in der erfindungsgemäßen hier beschriebenen Schaltungsanordnung bestehenden Tiefpaß. In einem Querzweig liegt ein Tiefpaß-Kondensator C1. In einem Längszweig liegen nachfolgend im einzelnen beschriebene Schaltmittel, durch die in Abhängigkeit von und proportional zu einer zugeführten, variablen, steuernden Pulstaktfrequenz die Grenzfrequenz des Tiefpasses einstellbar ist. Mit dieser Pulstaktfrequenz eintreffende Steuerimpulse treffen über eine Steuerklemme S ein.

Die genannten Schaltmittel im Längszweig sind durch einen aus Bipolar-Transistoren T1, T2, T3 und T4 aufgebauten Differenzverstärker gebildet, dessen Collectorwiderstand durch eine Stromspiegelschaltung realisiert ist. An den Ausgang des Differenzverstärkers ist der Tiefpaß-Kondensator C1 angeschlossen. Der genannte Eingangsanschluß ist mit dem Eingang des Differenzverstärkers verbunden, und zwar mit der Basis des Transistors T1.

Der Differenzverstärker ist mit den beiden Emittern der beiden Transistoren T1 und T2 mit einer Konstantstromquelle verbunden, die ebenfalls aus einem Bipolar-Transistor gebildet ist, und zwar dem Transistor T7. Dieser Transistor T7 ist Bestandteil eines sogenannten Stromspiegels, der aus den Transistoren T7 und T11 besteht und in der dargestellten Weise geschaltet ist und in an sich bekannter Weise arbeitet und wirksam ist. Die beiden Transistoren haben hochgradig gleiche elektrische Eigenschaften. Dadurch, daß beide Emitterströme in diesen beiden Transistoren zwangsläufig gleich groß sind, sind folglich auch beide Kollektor-Ströme gleich groß. Der Emitterstrom des Transistors T11 ist durch die Spannung am Kondensator C2 steuerbar. Folglich ist dadurch auch der Kollektorstrom des Transistors T11 steuerbar und damit auch der Kollektorstrom des Transistors T7, d.h. der Konstantstrom IO.

Die Ladung des Kondensators C2 erfolgt über den Widerstand R. Die mit der genannten Pulstaktfrequenz über die Steuerklemme S zugeführten Steuerimpulse werden einem monostabilen Kippglied MF zugeführt. Unabhängig von der Dauer und der Amplitude dieser Impulse gibt das Kippglied Impulse konstanter Amplitude und konstanter Dauer ab. Diese Ausgangsimpulse werden über den Widerstand R dem Kondensator C2 zugeführt, und dieser wird dadurch geladen. Der Widerstand R und der Kondensator C2 dienen gemeinsam als ein Integrationsglied, in dem der Widerstand R ein Längswiderstand ist und der Kondensator C2 ein Querkondensator. Die Wirkung dieses Integrationsgliedes besteht darin, daß sich am Kondensator C2 eine Spannung einstellt, die proportional der momentanen Frequenz der Steuerimpulse ist, die mit der genannten Pulstaktfrequenz über die Steuerklemme S zugeführt werden. Ent sprechend der jeweiligen momentanen Höhe dieser Pulstaktfrequenz stellt sich am Kondensator C2 eine dadurch bestimmte Spannung ein. Die Ladung des Kondensators C2 fließt in den Pausen zwischen den vom momostabilen Kippglied MF über den Widerstand R abgegebenen Ausgangsimpulsen zum Transistor T11 hin ab, der auf den Kondensator C2 also wie ein Verbraucher wirkt.

Nach Maßgabe der jeweils momentanen Pulstaktfrequenz stellt sich also ein Konstantstrom 10 ein, der das Verhalten des Differenzverstärkers bestimmt. Der Ausgangswiderstand des Differenzverstärkers, der den Längswiderstand des Tiefpasses nachbildet, ist nämlich proportional dem Emitterwiderstand der Differenzverstärker-Transistoren. Da dieser Emitterwidersand umgekehrt proportional zum Steuerstrom IO ist, ist auch der nachgebildete Längswiderstand des Tiefpasses umgekehrt proportional zur Steuer-Frequenz.

Mit Hilfe der erfindungsgemäßen Schaltungsanordnung wird erreicht, daß die Grenzfrequenz des Tiefpasses nach Maßgabe der momentanen Pulstaktfrequenz gesteuert wird. Diese Pulstaktfrequenz kann von einem laufenden Datenstrom abgeleitet sein. Entsprechende Daten können in verschieden großer Dichte übertragen werden. Hieraus resultiert eine entsprechend größere oder kleinere Übertragungsrate pro Zeiteinheit. Je größer diese relative Übertragungsrate ist, je höher wird die Grenzfrequenz des Tiefpasses eingestellt. Diese Einstellung ist stufenlos steuerbar.

## Ansprüche

1. Schaltungsanordnung für Tiefpaß-Filter mit einem Tiefpaß-Kondensator in einem Querzweig und mit solchen Schaltmitteln in einem Längszweig, durch die in Abhängigkeit von und proportional zu einer zugeführten, variablen, steuernden Impulstaktfrequenz die Grenzfrequenz des Tiefpasses einstellbar ist, **dadurch gekennzeichnet, daß** im Längszweig ein aus Bipolar-Transistoren aufgebauter Differenzverstärker liegt, dessen Collectorwiderstand durch eine Stromspiegel-Schaltung realisiert ist und an dessen Ausgang zur Bildung des Querzweiges der Tiefpaß-Kondensator angeschlossen ist, und der mit einer ebenfalls aus einem Bipolar-Transistor gebildeten Konstantstromquelle verbunden ist, und daß mit der Pulstaktfrequenz eintreffende Impulse einem monostabilen Kippglied zugeführt werden, dessen Ausgangsimpulse - über ein vorzugsweise aus einem Längswiderstand und einem Querkondensator bestehenden Integrationsglied geführt - zur Bildung einer die Konstantstromquelle steuernden, zur Frequenz proportionalen Steuerspannung dienen.

2. Schaltungsanordnung nach Anspruch 1, **dadurch gekennzeichnet, daß** die Konstantstromquelle durch eine Stromspiegelschaltung realisiert ist, wobei die Basen der Transistoren mit dem Integrationsglied, vorzugsweise mit dem ihm zugehörigen Querkondensator verbunden sind.

3. Schaltungsanordnung nach Anspruch 1, **dadurch gekennzeichnet, daß** der nichtinvertierende Eingang des Differenzverstärkers mit dem Eingangssignal und dessen invertierender Eingang mit dem Ausgangssignal verbunden ist.

3